# EUROPÄISCHE PATENTSCHRIFT

(11) **EP 0 801 293 B1**
(45) Veröffentlichungstag und Bekanntmachung des Hinweises auf die Patenterteilung: **05.07.2000**
(21) Anmeldenummer: 97105396.2
(22) Anmeldetag: 01.04.1997
(51) Int. Cl.: G01L 9/00, C22C 45/10

(54) **Druck- oder Differenzdruckmesser**
Pressure sensor or differential pressure sensor
Capteur de pression ou capteur de pression différentielle

(30) Priorität: 12.04.1996 DE 19614458
(43) Veröffentlichungstag der Anmeldung: 15.10.1997
(73) Patentinhaber: GRUNDFOS A/S, DK-8850 Bjerringbro (DK)
(72) Erfinder: Jensen, Niels Due, 8850 Bjerringbro (DK); Dyrbye, Karsten, Mammen, 8850 Bjerringbro (DK); Brown, Tina Romedahl, Sahl, 8850 Bjerringbro (DK); Andersen, Per Ellemose, 8850 Bjerringbro (DK)
(74) Vertreter: Vollmann, Heiko, Dipl.-Ing.

(56) Entgegenhaltungen:
- EP-A- 0 537 710
- EP-A- 0 548 470
- US-A- 4 686 764
- US-A- 4 897 360
- MICROMECHANICS OF ADVANCED MATERIALS. SYMPOSIUM IN HONOR OF PROFESSORS JAMES C.M.LI S 70TH BIRTHDAY. PROCEEDINGS, PROCEEDINGS OF MICROMECHANICS OF ADVANCED MATERIALS, CLEVELAND, OH, USA, 29 OCT.-2 NOV. 1995, ISBN 0-87339-294-9, 1995, WARRENDALE, PA, USA, TMS, USA, Seiten 295-300, XP002031037 CHEN H S: "Metallic glasses update"

## Beschreibung

Die Erfindung betrifft einen Druck- oder Differenzdrucksensor gemäß den im Oberbegriff des Anspruches 1 angegebenen Merkmalen sowie ein Verfahren zum Herstellen eines solchen Sensors.

Das Messen des Druckes oder Differenzdruckes in Fluiden zählt zu den wichtigsten Aufgaben bei der Überwachung technischer Anlagen. Heutzutage werden anstelle von Manometern in zunehmendem Maße Sensoren eingesetzt, die in Abhängigkeit des am Sensor anstehenden Druckes bzw. Differenzdruckes ein elektrisches Signal erzeugen bzw. modifizieren. Solche Sensoren sind nicht nur hinsichtlich der Baugröße und Meßgenauigkeit zu bevorzugen, sondern sie ermöglichen insbesondere auch eine einfache Einbindung in elektronische Regelungen, Überwachungen und dergleichen.

Aus US-PS 4,686,764, US-PS 4,732,042 und EP-A- 0 548 470 sind gattungsgemäße Sensoren bekannt. Die Membran dieser bekannten Sensoren, die einseitig oder im Fall des Einsatzes als Differenzdrucksensor zweiseitig mit wechselndem Druck beaufschlagbar ist, besteht aus Silizium. Auf dieser Siliziummembran sind Meßelemente in Form von Widerständen aufgebracht, die über ebenfalls auf der Membran aufgebrachte Leiterbahnen am Rande derselben kontaktierbar und in üblicher Weise als Meßbrücken verschaltbar sind. Anhand der Verstimmung der Meßbrücke kann die Auslenkung der Membran und somit der anstehende Druck bzw. die Differenz der anstehenden Drücke ermittelt werden. Derartige Schaltungsanordnungen sind hinlänglich bekannt (Dehnungsmeßstreifen).

Da die Widerstandsänderung der auf der Membran aufgebrachten Meßwiderstände auch temperaturabhängig ist, wird in der Regel unmittelbar neben dem Auslenkbereich der Membran ein Kompensationswiderstand auf derselben aufgebracht, über den eine Temperaturkompensation der Messung erfolgt.

Die aus Silizium bestehende Membran mit dem darauf aufgebrachten Meßelement erlaubt zwar eine Messung mit vergleichsweise hoher Genauigkeit auf kleinstem Raum, doch sind die Membran und die darauf befindliche Elektronik empfindlich, so daß sie einen Schutz benötigt, durch den ein unmittelbarer Kontakt des Fluids mit der Membran verhindert wird. Gemäß dem aus den einleitend erwähnten Druckschriften bekannten Stand der Technik wird ein solcher Schutz durch eine auf die Membran aufgebrachte Gelschicht - in EP-A 0 548 470 als zähflüssiges Druckmittlermedium bezeichnet - gebildet, die in einem Raum konstanten Volumens angeordnet und durch eine membranartige Schutzschicht abgedeckt ist. Das Fluid, dessen Druck zu ermitteln ist, steht also an dieser durch die Schutzschicht gebildeten Membran an, die darauf wirkenden Kräfte werden durch die Membran hindurch an das Druckmittelmedium, also das Gel, und dann auf die Siliziummembran weitergeleitet. Auch ist es bekannt, unter Verzicht auf die Schutzschicht die Siliziummembran mit einem Schutzgel zu versehen und in einem Gehäuse anzuordnen, das lediglich über eine vergleichsweise kleine Öffnung druckleitend mit dem Fluid verbunden ist, dessen Druck zu messen ist.

Nachteilig bei diesen Anordnungen ist zum einen der hohe Bauaufwand zum Schutz der Membran, zum anderen die durch den Schutz beeinträchtigten Meßeigenschaften. Je dicker und zäher nämlich die Schutzschicht ist, um so ungenauer ist die Messung. Andererseits muß die Schutzschicht einen zuverlässigen und dauerhaften Schutz der Siliziummembran sicherstellen, da ein unmittelbarer Kontakt mit dem Fluid in der Regel zur bleibenden Schädigung der Membran und damit zur Zerstörung des Sensors führt. Darüberhinaus ist bei den bekannten Konstruktionen die Kontaktierung der auf der Membran befindlichen Meßelemente aufwendig. Sie erfolgt in der Regel über einzelne blanke Drähte, die durch Bonden mit einer Leiterbahn auf der Membran und einer Leiterbahn auf einer Platine verbunden sind, die mit geringem Abstand zur Membran angeordnet ist und gegebenenfalls weitere Elektronikbauteile aufweist. Die Drähte müssen druckdicht aus dem Druckraum in den anderen Teil des Sensors herausgeführt werden.

Hiervon ausgehend liegt der Erfindung die Aufgabe zugrunde, einen Druck- oder Differenzdrucksensor so auszubilden, daß die vorerwähnten Nachteile weitgehend vermieden werden, so daß in konstruktiv einfacher Weise ein Sensor gebildet ist, dessen Membran einerseits feinfühlig auslenkbar, andererseits jedoch zuverlässig gegen äußere, durch das beaufschlagende Fluid gegebene Einflüsse geschützt ist. Darüberhinaus soll der Sensor einfach und kostengünstig in der Herstellung sein.

Diese Aufgabe wird gemäß der Erfindung durch einen Sensor erreicht, der die in Anspruch 1 aufgeführten Merkmale aufweist. Ein besonders effektives und kostengünstiges Verfahren zum Herstellen eines solchen Sensors, insbesondere der darin befindlichen Membran ist durch die in Anspruch 12 aufgeführten Merkmale gekennzeichnet.

Demgemäß sieht die Erfindung vor, daß der Schutz der Membran durch eine unmittelbar auf diese, das darauf befindliche Meßelement und die gegebenenfalls darauf befindliche weiteren Elektronikbauteile aufgebrachte elektrisch isolierende Schicht gebildet ist, die von einer mindestens flüssigkeitsdichten amorphen Metallschicht überdeckt ist. Die elektrisch isolierende Schicht kann extrem dünn sein, da sie lediglich die Aufgabe hat, sicherzustellen, daß die amorphe Metallschicht die auf der Membran angeordneten Leiter und Elektronikbauteile nicht kurzschließt. Andererseits ist sie aufgrund der Abdeckung durch die amorphe Metallschicht geschützt. Sie kann daher in der Regel so ausgebildet sein, daß sie die Auslenkung der Membran und damit die Meßgenauigkeit nicht spürbar beeinträchtigt. Die darüberliegende amorphe Metallschicht sorgt hingegen für einen wirksamen Schutz von Membran, darauf befindlichem Meßelement, gegebenenfalls darauf befindlicher Elektronikbauteile sowie der elektrisch isolierenden Schicht. Aufgrund dessen, daß sich die Metallschicht nicht in Kristallstruktur, sondern in amorpher Struktur befindet - dies wird auch als Metallglas bezeichnet - kann sie zum einen hochkorrosionsfest sein und ist zum anderen schon bei dünnster Schichtdicke flüssigkeits- und auch gasdicht. Derartige amorphe Metallschichten sind beispielsweise aus EP 0 537 710 A1, DE 42 16 150 A1, DE 38 14 444 A1 bekannt. Es wird in diesem Zusammenhang auch auf folgende Veröffentlichungen hingewiesen: Palmström, C. J.; J. Gyulai and J. W. Mayer in J. Vac. Sci. Technol. A1C21, April-June 1983, Seiten 452 ff..

Eine solche Metallschicht kann also extrem dünn sein, so daß sie die Auslenkung der Membran praktisch nicht beeinträchtigt und somit eine hohe Meßgenauigkeit gewährleistet.

Bevorzugt wird die Membran in an sich bekannter Weise aus Silizium gebildet, und zwar so, daß ein etwa plattenförmiger aus Silizium bestehender Träger entsteht, der lediglich einen die eigentliche Membran bildenden zentralen Teil geringerer Dicke aufweist. Dieser Siliziumträger kann dann in an sich bekannter Weise in Dünn-, Dickschichttechnik oder Siliziumtechnologie mit dem oder den Meßelementen, insbesondere Widerständen sowie Leiterbahnen und gegebenenfalls weiteren Elektronikbauteilen (zum Beispiel Widerstand für die Temperaturkompensation) versehen sein. Die darüberliegende elektrisch isolierende Schicht wird bevorzugt aus Polyimid, Siliziumoxid oder Siliziumnitrid bestehen, da diese Materialien bei vergleichsweise geringer Schichtdicke schon eine gute Isolierwirkung gewährleisten. Darüber ist dann die amorphe Metallschicht aus Metallglas angeordnet, die vorzugsweise auf der Basis von Chrom-Tantal oder Chrom-Titan besteht. Zweckmäßigerweise wird sowohl die elektrisch isolierende Schicht als auch die amorphe Metallschicht zu beiden Seiten der Membran aufgetragen, dann kann diese sowohl für Druck- als auch für Differenzdrucksensoren Verwendung finden. Die amorphe Metallschicht ist elektrisch leitend und läßt sich zweckmäßigerweise zur Abschirmung der darunterliegenden Elektronik nutzen, beispielsweise durch Erdung oder durch Potentialbeaufschlagung. Eine Potentialbeaufschlagung kann auch zur Hemmung oder Minderung der Korrosion sowie von Ablagerungen eingesetzt werden.

Um die Flüssigkeitsdichtheit der amorphen Metallschicht zu gewährleisten, sollte die Schichtdicke mindestens 0,1 µm aufweisen, dies entspricht etwa 700 Atomschichten. Andererseits sollte die Metallschicht die Beweglichkeit der Siliziummembran möglichst wenig beeinträchtigen. Insofern sollte die maximale Schichtdicke bei 5 µm liegen. Bevorzugt ist ein Bereich zwischen 0,5 und 1,5 µm, bei dem einerseits eine zuverlässige Dichtheit der amorphen Metallschicht und andererseits eine gute Beweglichkeit der Membran sichergestellt wird. Besonders vorteilhaft ist es, daß sich das gewählte Schichtmaterial im Auslenkbereich nur elastisch verformt, so daß Hystereseeffekte vermieden werden.

Bevorzugt erfolgt die Kontaktierung der auf der Membran bzw. auf dem Träger angeordneten Leiter jenseits der druckdichten Einspannung innerhalb der Halterung. Damit entfällt die sonst erforderliche druckdichte Durchführung der Leiter, wodurch der Bauaufwand erheblich verringert wird. Außerdem entfällt dadurch der sonst erforderliche zusätzliche Schutz dieser dünnen Drähte, die sehr empfindlich sind.

Die Einspannung der Membran bzw. des Trägers innerhalb der Halterung erfolgt entweder durch beidseitig der Membran liegende, diese umgebende und gegenüber der Halterung abdichtende O-Ringe oder aber durch Einkleben in die Halterung. Die Einspannung erfolgt zweckmäßigerweise symmetrisch zu beiden Seiten des Trägers, um Verspannungen zu verhindern.

Die Halterung selbst besteht im Bereich um die Membran herum bevorzugt aus zwei plattenförmigen Bauteilen, von denen eines eine Vertiefung zur Aufnahme der Membran bzw. des Trägers aufweist und zwischen denen die Membran druckdicht eingespannt bzw. eingeklebt ist. Innerhalb dieser plattenförmigen Bauteile sind zu beiden Seiten der Membran zueinander fluchtende Öffnungen vorgesehen, durch die das Fluid mit der Membran kommunizierend verbunden wird. Bei einer solchen Anordnung können die vorerwähnten Dichtringe, beispielsweise O-Ringe, in ringförmigen, sich um diese Öffnungen erstreckende Nuten liegen, welche die Dichtelemente formschlüssig halten.

Die Membran wird bevorzugt einstückig mit einem diese umgebenden Träger ausgebildet, wobei der Träger gegenüber der Membran im wesentlichen als starr zu betrachten ist, er weist eine entsprechend größere Dicke auf. Bevorzugt wird die elektrisch isolierende Schicht nicht nur auf die Membran, das darauf befindliche Meßelement bzw. die darauf befindlichen Meßelemente sowie gegebenenfalls weitere elektronische Bauteile aufgebracht, sondern über die gesamte Oberfläche des Trägers mit Ausnahme der Kontaktierungszonen, und zwar zu beiden Seiten. Dies wird zweckmäßigerweise durch geeignete Abscheideverfahren erfolgen, das nachfolgende Aufbringen der amorphen Metallschicht durch Aufdampfen zu beiden Seiten. Da in den Bereichen, in denen die spätere Kontaktierung der auf dem Träger befindlichen Leiter erfolgen soll, die Metallschicht eher hinderlich wäre, werden diese Bereiche des Trägers durch ein phototechnisches oder anderes geeignetes Verfahren vorher abgedeckt, so daß die Metallschicht in diesen Bereichen nach dem Aufdampfen durch Lösen der Abdeckschicht entfernt werden kann.

In besonders kostengünstiger Weise wird die Membran bzw. der Träger gemäß der Erfindung nicht einzeln, sondern in Form eines Wafers hergestellt. Es werden also eine Vielzahl von nebeneinander angeordneten Trägern mit darin befindlichen Membranen in Form eines Wafers in Dünn-, Dickschichttechnik oder Siliziumtechnologie hergestellt, danach die isolierende Schicht sowie nachfolgend die amorphe Metallschicht aufgebracht und gegebenenfalls in den zuvor abgedeckten Bereichen wieder entfernt. Erst dann wird der Wafer in einzelnen Membranen bzw. Träger zertrennt. Hierdurch kann der erfindungsgemäße Sensor in der Mittel- und Großserienfertigung sehr kostengünstig hergestellt werden. Die Kontaktierung der auf der Membran bzw. dem Träger befindlichen Leiter erfolgt zweckmäßigerweise nach dem Einspannen des Trägers innerhalb der Halterung, da dann die Membran bereits weitgehend geschützt innerhalb der Halterung liegt und die Kontaktierung mittels entsprechender Handhabungsautomaten vollständig maschinell erfolgen kann.

Die Erfindung ist nachfolgend anhand von in der Zeichnung dargestellten Ausführungsbeispielen näher erläutert. Es zeigen:
- Fig. 1: in schematischer Darstellung einen Längsschnitt durch einen Träger mit darin befindlicher Membran,
- Fig. 2: eine Draufsicht auf einen Träger nach Fig. 1, jedoch ohne abdeckende Schichten,
- Fig. 3: einen Längsschnitt durch die Halterung im Bereich der Einspannstelle in stark vereinfachter Darstellung,
- Fig. 4: eine andere Ausführung der Einspannung in Darstellung nach Fig. 3,
- Fig. 5: einen Teil der Halterung mit Dichtelement und Träger in Explosionsdarstellung und
- Fig. 6: den weiteren Teil der Halterung zu Fig. 5.

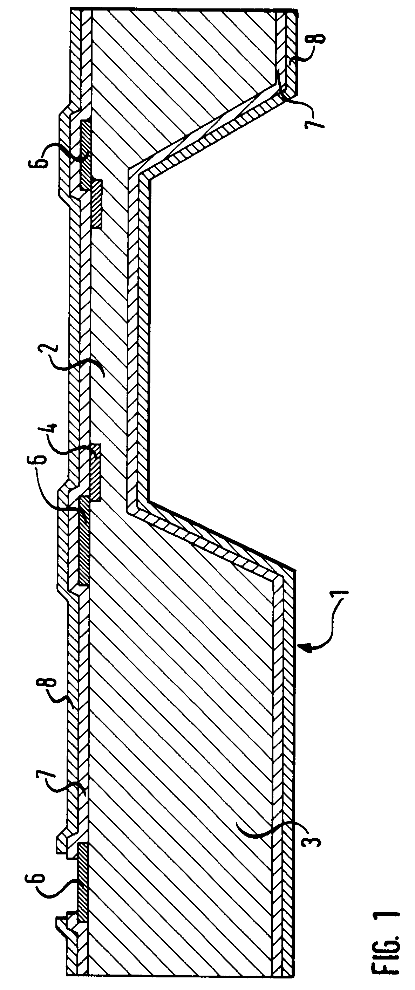

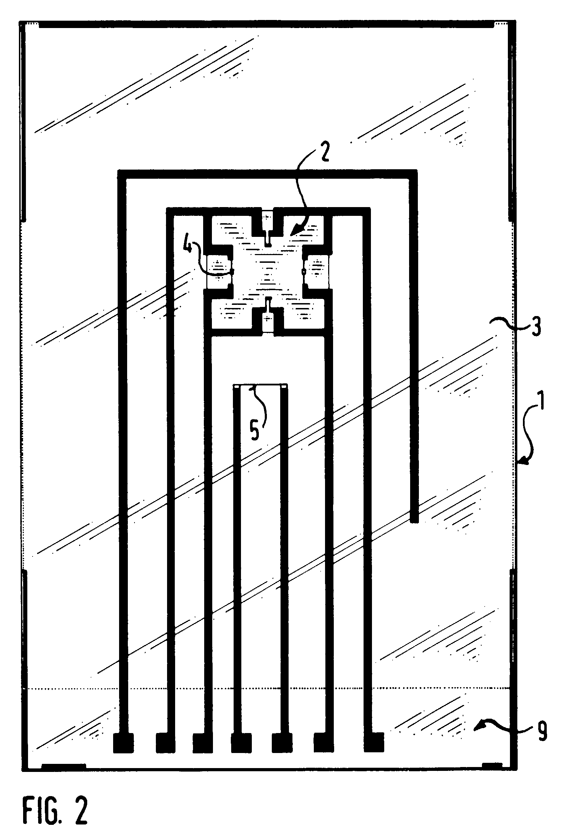

Der anhand der Figuren 1 und 2 dargestellte Träger 1 hat in Draufsicht (Fig. 2) eine etwa rechteckige Form. Er weist in einem mittleren etwa quadratischen Bereich 2 eine deutlich geringere Dicke auf. Deiser Bereich 2 bildet eine Membran eines Druck- oder Differenzdrucksensors, während der übrige Träger im wesentlichen als starr anzusehen ist. Träger 1 und Membran 2 sind aus Silizium gebildet. Im Bereich der Membran sind auf den Siliziumgrundkörper 3 vier Widerstände 4 zur Erfassung der Membranauslenkung sowie unmittelbar benachbart zur Membran 2 ein weiterer Widerstand 5 zur Temperaturkompensation des Sensors aufgebracht. Der elektrische Anschluß der Widerstände 4 und 5 erfolgt über ebenfalls unmittelbar auf dem Träger 1 aufgebrachte Leiterbahnen 6, die aus Aluminium bestehen. Die Leiteranordnung zu den Widerständen 4 ist schon vorbereitend zu einer Brückenschaltung ausgebildet, die Kontaktpunkte zu den Leiterbahnen 6 zur weiteren Verdrahtung liegen sämtlichst an einer Seite des Trägers 1, und zwar entfernt von der Membran 2.

Membran 2 und Träger 1 sind beidseitig von einer Siliziumoxidschicht 7 überdeckt. Diese Schicht 7 ist unmittelbar auf den Siliziumgrundkörper 3 bzw. die Widerstände 4 und 5 sowie die Leiterbahnen 6 aufgebracht. Die Silizumoxidschichten 7 zu beiden Seiten des Trägers 1 sind jeweils von einer Metallglasschicht 8 überdeckt. Diese amorphe Metallschicht ist aufgedampft und weist eine Dicke von etwa 1 µm, das sind etwa 7.000 Atomschichten auf. Die Metallglasschicht 8 ist flüssigkeits- und gasundurchlässig. Sie hat eine gegenüber kristallinen Edelstählen deutlich höhere Korrosionsfestigkeit und Härte. Dennoch beeinträchtigt sie das Meßverhalten der Membran 2 praktisch nicht, da sich diese Schicht nur eleastisch verformt. Sie schützt diese somit in nahezu optimaler Weise vor äußeren Einflüssen. Um einen Kurzschluß der auf dem Siliziumgrundkörper 3 gebildeten Widerstände und Leiterbahnen durch die Metallglasschicht 8 zu verhindern, ist die elektrisch isolierende Siliziumoxidschicht 7 vorgesehen.

Bei dem beschriebenen Ausführungsbeispiel besteht die Metallglasschicht 8 aus einer amorphen Metallegierung auf der Grundlage von Chrom-Tantal bzw. Chrom-Titan. Es wird in diesem Zusammenhang auf EP 0 537 710 A1 verwiesen.

Wie in Fig. 2 dargestellt, ist ein sich parallel zur Schmalseite des Trägers 1 verlaufender Streifen 9 vorgesehen, in dem die Leiterbahnen 6 weder durch eine Siliziumoxidschicht 7 noch durch eine Metallglasschicht 8 abgedeckt sind. Hier laufen die Leiterbahnen 6 zum Zwecke der Kontaktierung (Bonding) aus.

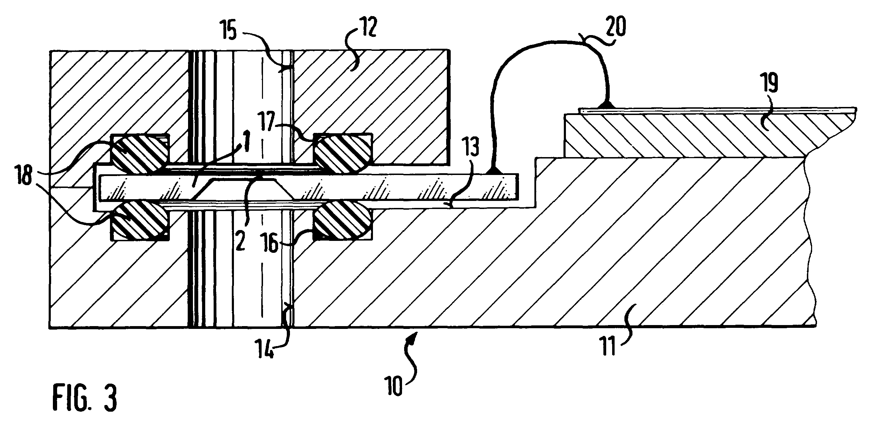

Der vorbeschriebene Träger 1 ist in einer Halterung 10 derart druckdicht eingegliedert, daß die Membran 2 beidseitig fluidbeaufschlagbar ist. Anhand von Fig. 3 ist dies schematisch dargestellt. Die Halterung 10 besteht dort aus einem plattenförmigen Grundkörper 11 und einer Abdeckplatte 12, die miteinander unter Eingliederung des Trägers 1 verbunden sind. Der plattenförmige Grundkörper 11 weist eine flächige Vertiefung 13 auf, etwa in der Größe des Trägers 1, zur Aufnahme desselben. Weiterhin weisen der plattenförmige Grundkörper 11 und die Abdeckplatte 12 zueinander fluchtende Ausnehmungen 14 und 15 auf, durch die die Membran 2 fluidbeaufschlagbar ist. Die Bauteile 11 und 12 weisen jeweils konzentrisch zu ihren Ausnehmungen 14 und 15 Ringnuten 16 und 17 auf, in denen O-Ringe 18 liegen, welche den Träger 1 druckdicht zwischen den Bauteilen 11 und 12 einspannen. Die Anordnung ist so gewählt, daß die Membran 2 innerhalb der Ausnehmungen 14 ud 15 frei zugänglich ist, während der Streifen 9, der zur Kontaktierung der Enden der Leiterbahnen 6 vorgesehen ist, jenseits der Abdichtung innerhalb der Halterung 10 liegt. Im übrigen ist die Halterung so ausgebildet, daß lediglich der Bereich der Ausnehmungen 14 und 15 fluidbeaufschlagbar ist, der übrige Teil jedoch gegenüber dem Fluid abgedichtet ist.

Auf dem Grundkörper 11 ist eine Platine 19 angeordnet, welche weitere elektronische Bauteile zur Aufbereitung des Meßsignales aufweist. Diese Platine 19 ist über Leiter 20 elektrisch mit den Leiterbahnen 6 des Trägers 1 verbunden. Die Kontaktierung erfolgt durch Anlöten oder Anschweißen der Leiter 20 an den durch den Streifen 9 frei zugänglichen Enden der Leiterbahnen 6 (sogenanntes Bonding).

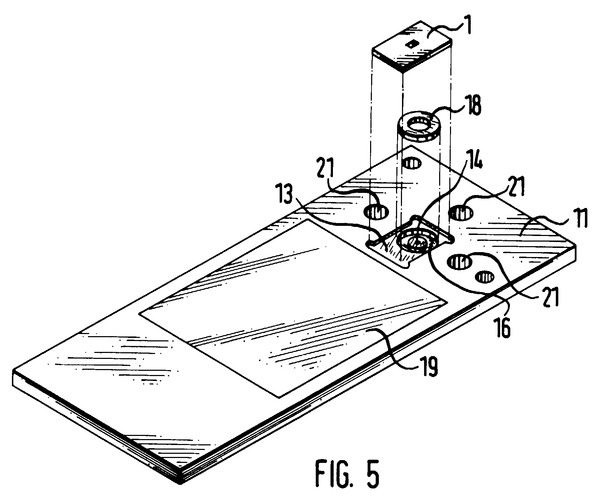

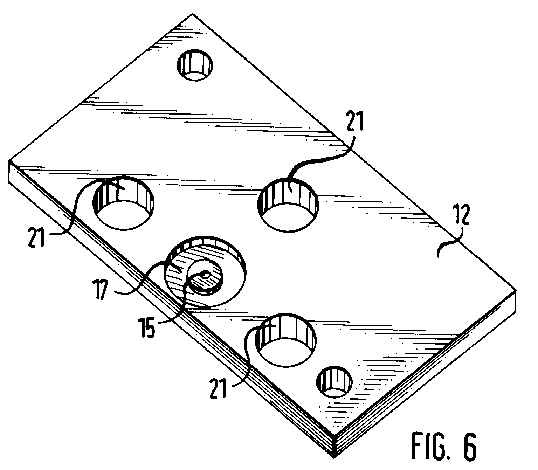

Der weitere elektronische, elektrische und vorrichtungsmäßige Aufbau des Differenzdrucksensors ist in an sich bekannter Weise ausgeführt und wird deshalb hier nicht im einzelnen nicht erörtert. Der Aufbau, soweit es die Halterung 10 angeht, ist anhand der Figuren 5 und 6 näher veranschaulicht. Dort sind zur Verbindung der plattenförmigen Bauteile 11 und 12 neben der Vertiefung 13 angeordnete Bohrungen 21 jeweils fluchtend in Grundkörper 11 und Abdeckplatte 12 vorgesehen, durch die eine Schraub- oder Nietverbindung zwischen den beiden Bauteilen hergestellt werden kann.

Der so gebildete Sensor kann als Drucksensor Verwendung finden, wenn die Membran 2 nur einseitig druckbeaufschlagt wird. Zur Verwendung als Differenzdrucksensor wird die Membran 2 beidseitig fluidbeaufschlagt.

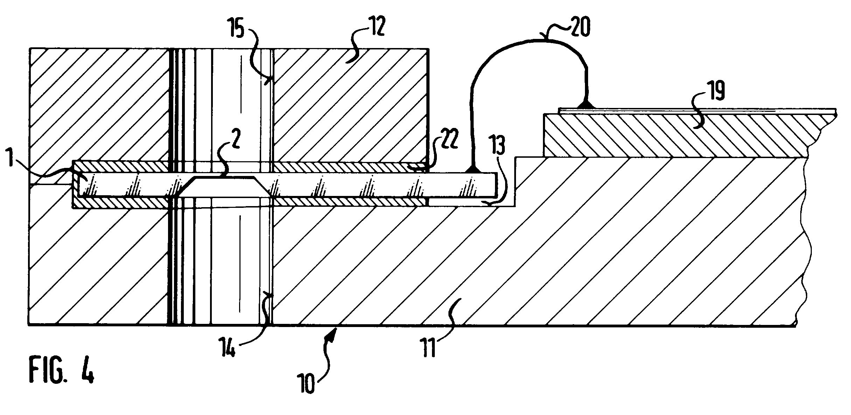

Anhand von Fig. 4 ist eine alternative Einspannung des Trägers 1 zwischen den Bauteilen 11 und 12 dargestellt. Dieses Ausführungsbeispiel unterscheidet sich von dem anhand von Fig. 3 dargestellten dadurch, daß auf die Ringnuten 16, 17 sowie die O-Ringe 18 verzichtet worden ist und statt dessen der Träger 1 mittels einer Klebschicht 22 zwischen dem plattenförmigen Grundkörper 11 und der Abdeckplatte 12 eingegliedert ist. Diese Eingliederung ist insofern von Vorteil, als die auftretenden Spannungen im Träger 1 und in der Membran 2 deutlich geringer als bei der vorbeschriebenen Einspannung sind. Dies ist in Hinblick auf die Meßgenauigkeit und Linearität der Messung von Vorteil. In jedem Fall jedoch erfolgt die Einspannung des Trägers 1 zwischen den Bauteilen 11 und 12 vor Kontaktierung der Enden der Leiterbahnen 6, da der vergleichsweise empfindliche Träger 1 nach dem Eingliedern in die Halterung 10 wesentlich einfacher und sicherer zu handhaben ist als vorher.

### Bezugszeichenliste

- 1: Träger
- 2: Membran
- 3: Siliziumgrundkörper
- 4: Widerstände
- 5: Widerstand
- 6: Leiterbahnen
- 7: Siliziumoxidschicht
- 8: Metallglasschicht
- 9: Streifen
- 10: Halterung
- 11: plattenförmiger Grundkörper
- 12: Abdeckplatte
- 13: Vertiefung
- 14: Ausnehmungen
- 15: Ausnehmung
- 16: Ringnut
- 17: Ringnut
- 18: O-Ringe
- 19: Platine
- 20: Leiter
- 21: Bohrungen
- 22: Klebstoff

## Patentansprüche

1. Druck- oder Differenzdrucksensor mit einer Membran (2) mit mindestens einem darauf befindlichen Meßelement (4) und mit einer Auswertelektronik zum Erfassen einer Membranauslenkung, und mit einem Schutz gegen Umgebungseinflüsse sowie mit einer die Membran druckdicht einspannenden Halterung (10), dadurch gekennzeichnet, daß der Schutz durch eine unmittelbar auf die Membran (2), das darauf befindliche Meßelement (4) und die gegebenfalls darauf befindlichen Elektronikteile (5) aufgebrachte elektrisch isolierende Schicht (7) gebildet ist, die von einer mindestens flüssigkeitsdichten, amorphen Metallschicht (8) überdeckt ist.

2. Sensor nach Anspruch 1, dadurch gekennzeichnet, daß unter der elektrisch isolierenden Schicht (7) liegende Leiter (6) außerhalb einer druckdichten Einspannung kontaktiert sind.

3. Sensor nach Anspruch 1 oder 2, dadurch gekennzeichnet, daß die Membran (2) im wesentlichen aus Silizium, daß die elektrisch isolierende Schicht (7) aus Siliziumoxid, Siliziumnitrit oder Polyimid und daß die amorphe Metallschicht (8) aus Metallglas, vorzugsweise auf der Basis von Chrom-Tantal oder Chrom-Titan, besteht.

4. Sensor nach einem der vorhergehenden Ansprüche, dadurch gekennzeichnet, daß die Membran (2) Teil eines plattenförmigen Trägers (1) und einstückig mit diesem ausgebildet ist, wobei die Einspannung der Membran (2) in der Halterung (10) im Bereich des Trägers (1) erfolgt.

5. Sensor nach einem der vorhergehenden Ansprüche, dadurch gekennzeichnet, daß die amorphe Metallschicht (8) eine Dicke von 0,1 bis 5 µm, vorzugsweise von 0,5 bis 1,5 µm, aufweist.

6. Sensor nach einem der vorhergehenden Ansprüche, dadurch gekennzeichnet, daß die Membran (2) bzw. der Träger (1) zu beiden Seiten jeweils unter Zwischenschaltung eines Dichtelementes (18), vorzugsweise eines O-Rings in der Halterung (10), eingespannt ist.

7. Sensor nach einem der vorhergehenden Ansprüche, dadurch gekennzeichnet, daß die Membran (2) bzw. der Träger (1) durch Kleben (22) in die Halterung (10) eingegliedert ist.

8. Sensor nach einem der vorhergehenden Ansprüche, dadurch gekennzeichnet, daß die Halterung (10) zwei plattenförmige Bauteile (11, 12) mit einer Vertiefung (13) zur Aufnahme der Membran (2) bzw. des Trägers (1) aufweist, zwischen denen die Membran (2) eingespannt ist und die zueinander fluchtende Öffnungen (14, 15) zur Membran (2) hin aufweisen.

9. Sensor nach Anspruch 8, dadurch gekennzeichnet, daß in jedem plattenförmigen Bauteil (11, 12) eine zur Membran (2) bzw. zum Träger (1) hin offene, ringförmige Nut (16, 17) zur Aufnahme eines ringförmigen Dichtelementes (18) vorgesehen ist.

10. Sensor nach einem der vorhergehenden Ansprüche, dadurch gekennzeichnet, daß die amorphe Metallschicht (8) elektrisch leitend mit einem Potential oder Erde verbindbar ist.

11. Sensor nach einem der Ansprüche 4 bis 10, dadurch gekennzeichnet, daß der Träger im Bereich der Einspannung elektrisch isoliert ausgebildet ist.

12. Verfahren zum Herstellen eines Druck- oder Differenzdrucksensors, insbesondere nach einem der vorhergehenden Ansprüche, dadurch gekennzeichnet, daß eine in Dünn-, Dickschichttechnik oder Siliziumtechnologie mit einem Meßelement versehene Membran durch Belegen mit einer elektrisch isolierenden Schicht sowie nachfolgend durch Aufdampfen mit einer amorphen Metallschicht versehen wird.

13. Verfahren nach Anspruch 12, dadurch gekennzeichnet, daß das auf der Membran befindliche Meßelement nach dem Einspannen der Membran in einer Halterung kontaktiert wird.

14. Verfahren nach Anspruch 12 oder 13, dadurch gekennzeichnet, daß mehrere Träger in Form eines Wafers oder einer Oblate zusammenhängend hergestellt werden, daß die Meßelemente und elektrischen Leitungsverbindungen sowie gegebenenfalls weitere elektonische Bauteile in Dünn-, Dickschichttechnik oder Siliziumtechnologie aufgebracht werden, wonach das Belegen der isolierenden Schicht und nachfolgend das Aufdampfen der amorphen Metallschicht erfolgt und daß danach der Wafer in einzelne Träger mit Membranen zertrennt wird.

15. Verfahren nach Anspruch 14, dadurch gekennzeichnet, daß vor dem Aufdampfen der amorphen Metallschicht Bereiche des Wafers fototechnisch abgedeckt werden und daß danach die aufgedampfte Metallschicht in diesen zuvor abgedeckten Bereichen entfernt wird.

## Claims

1. A pressure- or differential pressure sensor with a membrane (2) with at least one measuring element (4) situated thereon and with an evaluation electronic arrangement for detecting a membrane deflection, and with a protection against environmental influences and also with a mounting (10) clamping the membrane in a pressure-tight manner, characterised in that the protection is formed by an electrically insulating layer (7) applied directly onto the membrane (2), the measuring element (4) situated thereon and the electronic parts (5) possibly situated thereon, which layer (7) is covered by an at least fluid-tight, amorphous metal layer (8).

2. The sensor according to Claim 1, characterised in that conductors (6) lying under the electrically insulating layer (7) are contacted outside a pressure-tight fixing.

3. The sensor according to Claim 1 or 2, characterised in that the membrane (2) consists substantially of silicon, that the electrically insulating layer (7) consists of silicon oxide, silicon nitrite or polyimide and that the amorphous metal layer (8) consists of metal glaze, preferably based on chromium tantalum or chromium titanium.

4. The sensor according to one of the preceding claims, characterised in that the membrane (2) is part of a plate-shaped support (1) and is constructed in one piece therewith, the fixing of the membrane (2) taking place in the mounting (10) in the region of the support (1).

5. The sensor according to one of the preceding claims, characterised in that the amorphous metal layer (8) has a thickness of 0.1 to 5 µm, preferably of 0.5 to 1.5 µm.

6. The sensor according to one of the preceding claims, characterised in that the membrane (2) or the support (1) is fixed on both sides respectively with intercalation of a sealing element (18), preferably an O-ring in the mounting (10).

7. The sensor according to one of the preceding claims, characterised in that the membrane (2) or respectively the support (1) is incorporated by gluing (22) into the mounting (10).

8. The sensor according to one of the preceding claims, characterised in that the mounting (10) has two plate-shaped components (11, 12) with a depression (13) to receive the membrane (2) or respectively the support (1), between which the membrane (2) is fixed and the openings (14, 15) in alignment with each other point towards the membrane (2).

9. The sensor according to Claim 8, characterised in that in each plate-shaped component (11, 12) an annular groove (16, 17), open towards the membrane (2) or respectively to the support (1), is provided to receive an annular sealing element (18).

10. The sensor according to one of the preceding claims, characterised in that the amorphous metal layer (8) is connectable in an electrically conducting manner with a potential or earth.

11. The sensor according to one of Claims 4 to 10, characterised in that the support is constructed so as to be electrically insulated in the region of fixing.

12. A method for the production of a pressure- or differential pressure sensor, in particular according to one of the preceding claims, characterised in that a membrane, provided with a measuring element by thin-, thick layer technology or silicon technology, is provided with an amorphous metal layer by covering with an electrically insulating layer and subsequently by evaporation.

13. The method according to Claim 12, characterised in that the measuring element situated on the membrane is contacted after the clamping of the membrane in a mounting.

14. The method according to Claim 12 or 13, characterised in that several supports are produced in a cohesive manner in the form of a wafer, that the measuring elements and electrical lead connections and also possibly further electronic components are applied by thin-, thick layer technology or silicon technology, after which the covering of the insulating layer and thereafter the evaporation of the amorphous metal layer takes place and that thereafter the wafer is divided into individual supports with membranes.

15. The method according to Claim 14, characterised in that before the evaporation of the amorphous metal layer, regions of the wafer are covered by phototechnology and that thereafter the evaporated metal layer in these previously covered regions is removed.

## Revendications

1. Capteur de pression ou de pression différentielle comprenant une membrane (2), sur laquelle se trouve au moins un élément de mesure (4) et qui comporte une électronique de traitement pour détecter une déviation de la membrane, et comprenant également une protection contre les influences de l'environnement ainsi qu'un ensemble de montage (10) enserrant la membrane de manière étanche à la pression, caractérisé en ce que la protection est formée par une couche électriquement isolante (7), qui est appliquée directement sur la membrane (2), sur l'élément de mesure (4) se trouvant dessus et sur les composants électroniques (5) se trouvant le cas échéant dessus, et qui est recouverte d'une couche de métal amorphe (8) au moins étanche aux liquides.

2. Capteur selon la revendication 1, caractérisé en ce que des conducteurs (6) se trouvant sous la couche électriquement isolante (7) ont leurs connexions réalisées à l'extérieur d'une zone de serrage étanche à la pression.

3. Capteur selon la revendication 1 ou 2, caractérisé en ce que la membrane (2) est réalisée essentiellement en silicium, en ce que la couche électriquement isolante (7) est réalisée en oxyde de silicium, en nitrure de silicium ou en un polyimide, et en ce que la couche de métal amorphe (8) est réalisée en métal-verre, de préférence à base de chrome-tantale ou de chrome-titane.

4. Capteur selon l'une des revendications précédentes, caractérisé en ce que la membrane (2) fait partie d'un support (1) en forme de plaque et est réalisée d'un seul tenant avec celui-ci, le serrage de la membrane (2) dans l'ensemble de montage (10) s'effectuant dans la zone du support (1).

5. Capteur selon l'une des revendications précédentes, caractérisé en ce que la couche de métal amorphe (8) présente une épaisseur de 0,1 à 5 µm, de préférence de 0,5 à 1,5 µm.

6. Capteur selon l'une des revendications précédentes, caractérisé en ce que la membrane (2) ou le support (1) est enserré dans l'ensemble de montage (10), sur les deux faces, avec interposition sur chacune d'elles d'un élément d'étanchéité (18), de préférence d'un joint torique.

7. Capteur selon l'une des revendications précédentes, caractérisé en ce que la membrane (2) ou le support (1) est intégré dans l'ensemble de montage (10), par collage (22).

8. Capteur selon l'une des revendications précédentes, caractérisé en ce que l'ensemble de montage (10) comprend deux pièces en forme de plaque (11, 12) avec un creux (13) destiné à recevoir la membrane (2) ou le support (1), pièces entre lesquelles est enserrée la membrane (2) et qui présentent des ouvertures (14, 15) mutuellement alignées, débouchant sur la membrane (2).

9. Capteur selon la revendication 8, caractérisé en ce que dans chaque pièce en forme de plaque (11, 12) est prévue une rainure (16, 17) de forme annulaire, ouverte en direction de la membrane (2) ou du support (1), et destinée à recevoir un élément d'étanchéité (18) de forme annulaire.

10. Capteur selon l'une des revendications précédentes, caractérisé en ce que la couche de métal amorphe (8) peut être reliée, de manière électriquement conductrice, à un potentiel ou à la terre.

11. Capteur selon l'une des revendications 4 à 10, caractérisé en ce que le support est électriquement isolé dans la zone du serrage.

12. Procédé de fabrication d'un capteur de pression ou de pression différentielle, notamment selon l'une des revendications précédentes, caractérisé en ce qu'une membrane, munie d'un élément de mesure selon la technique des couches minces, des couches épaisses ou la technologie du silicium, est dotée, par revêtement, d'une couche électriquement isolante, ainsi qu'à la suite, par métallisation sous vide, d'une couche de métal amorphe.

13. Procédé selon la revendication 12, caractérisé en ce que l'élément de mesure se trouvant sur la membrane est doté de ses connexions après le serrage de la membrane dans un ensemble de montage.

14. Procédé selon la revendication 12 ou 13, caractérisé en ce que plusieurs supports sont fabriqués regroupés sous la forme d'une plaquette ou d'une pastille, en ce que les éléments de mesure et les conducteurs de connexion électrique, ainsi que, le cas échéant, d'autres composants électroniques, sont appliqués par la technique des couches minces, des couches épaisses ou la technologie du silicium, après quoi est effectuée l'application de la couche isolante suivie du dépôt par métallisation sous vide de la couche de métal amorphe, et en ce que la plaquette est ensuite scindée en supports individuels munis de membranes.

15. Procédé selon la revendication 14, caractérisé en ce qu'avant le dépôt par métallisation sous vide de la couche de métal amorphe, des zones de la plaquette sont masquées par technique photographique, et en ce que la couche de métal déposée par métallisation sous vide est ensuite éliminée dans ces zones préalablement masquées.
